# EUROPÄISCHE PATENTANMELDUNG

(11) **EP 1 179 860 A1**
(43) Veröffentlichungstag der Anmeldung: **13.02.2002**
(21) Anmeldenummer: 00116272.6
(22) Anmeldetag: 09.08.2000
(51) Int. Cl.: H01L 41/047, H01L 41/083

(54) **Piezoaktorkontaktierung**

(71) Anmelder: Piezomechanik GmbH, 81673 München (DE)
(72) Erfinder: Pickelmann, Lutz, Dr., 81673 München (DE)
(74) Vertreter: Schwabe - Sandmair - Marx

(57) **Zusammenfassung**

Die Erfindung betrifft eine Funktionseinrichtung zur Erzeugung von mechanischen Schwingungen, insbesondere einen Piezostapelaktor, welche wenigstens einen elektrischen Anschluss bzw. wenigstens einen elektrischen Kontakt, insbesondere eine Aussenelektrode umfasst, wobei erfindungsgemäß der elektrische Kontakt bzw. der elektrische Anschluss faser- bzw. stäbchenartige Bestandteile enthält, die mechanisch stabilisierend wirken. Die faser- bzw. stäbchenartigen Bestandteile sind entweder selbst elektrisch leitend, wie etwa Karbonfasern, oder isolierend und mit leitendem Material beschichtet, wie zum Beispiel Glasfasern.

## Beschreibung

Die Erfindung betrifft eine Funktionseinrichtung zur Erzeugung von mechanischen Schwingungen mit wenigstens einem elektrischen Anschluss bzw. wenigstens einem elektrischen Kontakt gemäß dem Oberbegriff des Patentanspruchs 1. In diesem Zusammenhang betrifft die Erfindung auch Piezoaktoren bzw. Piezostapelaktoren und deren Kontaktierung zur Versorgung mit elektrischer Energie. Insbesondere betrifft die Erfindung Niedervoltpiezostapelaktoren und deren Kontaktierung.

Im Stand der Technik sind verschiedene Funktionseinrichtungen bekannt, die zur Erzeugung oder zur Kompensation mechanischer Schwingungen und insbesondere hochfrequenter mechanischer Schwingungen aufgebaut sind. Hier gibt es beispielsweise elektrostriktorisch arbeitende Funktionseinheiten wie auch Funktionskeramiken, die als Ultraschallgeneratoren, etwa zur Reinigung, eingesetzt werden. Andererseits gibt es auch Piezoaktoren und insbesondere Piezostapelaktoren, die eingesetzt werden, um hochfrequente mechanische Schwingungen zu erzeugen. Derartige Piezostapelaktoren können auch eingesetzt werden, um konstant Kräfte auszuüben, beispielsweise um Entfernungen einzustellen. Auch für die Betätigung von Ventilen, die Erzeugung von Druck und dergleichen können Piezoaktoren und insbesondere Niedervoltpiezostapelaktoren eingesetzt werden.

Beispielsweise in Dieselmotoren können Niedervoltpiezostapelaktoren bei der Dieseleinspritzung eingesetzt werden, wobei die Aktoren auch hier hohen Wechselbelastungen, wie z. B. pulsartigen Betriebsweisen, ausgesetzt sind. D.h., durch die mittels der angelegten Niedervoltwechselspannungen erzeugten schnellen Dehnungen bzw. Kontraktionen werden die Kontakte wie auch die Anschlüsse und Zuleitungen derartiger Funktionseinrichtungen stark belastet, da die Kontakte, beispielsweise Oberflächenelektroden oder dgl., wie auch die Anschlüsse, die Ausdehnungen und Kontraktionen der Funktionseinrichtungen, beispielsweise der Piezoscheiben, die einen Piezostapelaktor ausmachen, nicht mitmachen. Insbesondere bei Schwingungen mechanischer Art, die zu hohen Beschleunigungen führen, werden Anschlüsse bzw. Elektroden extrem belastet. Das Material, aus dem die Kontakte und die Anschlüsse hergestellt sind, ist dabei meistens zu Zwecken einer ausreichenden Leitfähigkeit aus einem metallischen Werkstoff, wobei Lote, wie etwa übliche Blei-Zinn-Lote, Kupferlote oder dgl. Anwendung finden. Auch werden Polymere und insbesondere leitfähige Polymere zur Kontaktierung eingesetzt, und auch Dickschichtpasten, Leitlacke sowie Leitkleber, die auch mit leitenden Füllstoffen, beispielsweise Silberpulver oder dgl. gefüllt sind, werden eingesetzt, um beispielsweise Oberflächenelektroden auszubilden.

All diese Materialien der herkömmlichen Kontaktierungs- und Anschlusstechnologien leiden bereits nach kurzer Funktionsdauer einer Funktionseinrichtung nach dem Stand der Technik und es kommt zu diversen Schäden. Häufige Schäden sind etwa eine elektrische Unterbrechung der Kontaktierung oder das Abbranden, wenn sich in Folge einer Rissbildung auf einem Oberflächenkontakt ein Lichtbogen bildet, der zu einer Verdampfung des Kontaktmaterials bzw. zu einem Verbrennen des Kontaktmaterials führen kann. Auch die Zuleitungen können einfach durch die Schwingungen ermüden und brechen. Sämtliche dieser und weitere existierender Schädigungsmöglichkeiten, etwa Ermüdungsbrüche bzw. -risse, führen unmittelbar zu einem Ausfall der Funktionseinrichtung.

Gemäß dem Stand der Technik werden Kontaktbahnen auf deaktivierte Bereiche des Piezostapels aufgebracht, wodurch der mechanische Stress nicht mehr an der Oberfläche des Aktors auftritt, sondern im Inneren der Keramik am Übergang der inaktiven Bereiche zu den aktiven Bereichen.

Es ist dementsprechend eine Aufgabe gemäß der vorliegenden Erfindung, eine Funktionseinrichtung zur Erzeugung bzw. Kompensation von mechanischen Schwingungen vorzuschlagen, bei der die obigen Probleme so weit als möglich ausgeräumt sind. Dabei soll gemäß der Erfindung auch eine neue Kontaktierungs- bzw. Zuleitungstechnologie vorgeschlagen werden, die mechanischen Belastungen ganz besonders der hochfrequenten Art besser standzuhalten vermag.

Gemäß der Erfindung wird diese Aufgabe durch eine Funktionseinrichtung gemäß dem Patentanspruch 1 gelöst.

Zweckmäßige Ausführungsformen der erfindungsgemäßen Funktionseinrichtung gehen aus den Unteransprüchen hervor.

Die gemäß der Erfindung erzielbaren Vorteile beruhen auf einer Funktionseinrichtung, bei der der elektrische Anschluss und/oder der elektrische Kontakt mit faser- bzw. stäbchenartigen Bestandteilen verstärkt ist, die den elektrischen Anschluss bzw. den elektrischen Kontakt mechanisch stabilisieren. D.h., während das elektrisch leitende Material, das der elektrische Kontakt bzw. der elektrische Anschluss enthält, eine gute elektrische Leitfähigkeit, jedoch eine mindere mechanische Stabilität aufweist, führen die faser- bzw. stäbchenartigen Zusätze überraschenderweise dazu, dass einerseits die elektrischen Eigenschaften des elektrischen Kontakts bzw. des elektrischen Anschlusses nicht leiden und andererseits deren mechanische Stabilität und Dauerhaftigkeit sowie deren Zuverlässigkeit ganz erheblich, d.h. beispielsweise sogar um mehrere 10er-Potenzen, zunehmen.

Vorteilhafterweise sind die faser- bzw. stäbchenartigen Bestandteile in einer Konzentration vorgesehen, so dass sie sich wenigstens Bereichsweise überdecken bzw. aneinander anschließen, so dass sie einen wenigstens stellenweise vorhandenen durchgängigen Verbindungspfad ergeben. Um die Stabilität beispielsweise einer Oberflächenelektrode über deren gesamte Fläche zu erzielen, sollten die Bestandteile in einer Konzentration vorgesehen werden, so dass sich durchgängige Perkolationspfade ergeben. Prinzipiell würde es aber auch schon eine Verbesserung darstellen, wenn die Bestandteile in einer Konzentration vorgesehen sind, so dass beispielsweise bei Piezostapelaktoren die Spalte zwischen den einzelnen Piezoscheiben des Piezostapels von entsprechenden Fasern bzw. Stäbchen überdeckt werden, so dass diese hochbelasteten Bereiche einer Oberflächenelektrode verstärkt und damit mechanisch stabilisiert werden.

Die meanderförmige oder sonst wie nichtgestreckte Anordnung der Fasern und/oder Stäbchen kann auch bewirken, dass zwar lokal eine hohe Zugfestigkeit/Wechselbelastbarkeit entsteht, aber keine langreichweitigen Zugkräfte aufgebaut werden.

Die faser- bzw. stäbchenartigen Bestandteile können dabei eine Länge in einem Bereich von etwa 1mm bis ca. 10 mm aufweisen. Diese Abmessungen eignen sich besonders, wenn entsprechende Bestandteile zu dem Material hinzugegeben werden sollen, aus dem ein leitender Oberflächenkontakt, d.h. beispielsweise eine leitende Oberflächenelektrode, hergestellt werden soll. Für elektrische Zuleitungen eigenen sich natürlich auch über große Bereiche fortgesetzte Fasern oder Litzen, die aus einem mechanisch hochbelastbaren Material sein sollten, das jedoch nicht notwendiger Weise auch elektrisch leitend ist, da die elektrische Leitung von anderen Fasern bzw. Litzen, beispielsweise Kupferlitzen, übernommen werden kann.

Vorteilhafterweise können die faser- bzw. stäbchenartigen Bestandteile wenigstens teilweise bzw. jeweils wenigstens eine Wellung, einen Bogen oder dgl. haben, die unter Belastung Stauchungen bzw. Zugbelastungen kompensieren können. Natürlich kann das Material der faser- bzw. stäbchenartigen Bestandteile selbst auch dehnbar sein und Belastungen aufnehmen und kompensieren. Dabei können die Bestandteile auch meanderartig ausgebildet sein bzw. können die faser- bzw. stäbchenartigen Bestandteile auch meanderförmig, in einem zick-zack-Muster, in einem welligen Muster oder in einer anderen statistischen Weise verlegt werden, so dass Zug- bzw. Dehnungsbelastungen wie auch Stauchungsbelastungen dadurch kompensiert werden können, dass die faser- bzw. stäbchenartigen Bestandteile lang-bzw. geradegezogen bzw. gebogen oder gestaucht werden. Das Material kann auch elastisch verformbar sein, so dass eine Dehnung zu einer Verdünnung des Durchmessers bzw. eine Stauchung zu einer Verdickung des Durchmessers der Fasern bzw. Stäbchen führt.

Die Fasern bzw. Stäbchen weisen bevorzugt eine hohe mechanische Zugfestigkeit auf und können aus elektrisch leitendem und/oder elektrisch isolierendem Material hergestellt sein. Als Material kommen z. B. Kunststoffe verschiedener Art, wie sie z.B. aus CFK-Verbindungen bekannt sind, z. B. Karbonfasern und dgl. mehr in Betracht. Karbonfasern können z. B. mit einem leitenden Material beschichtet werden, beispielsweise mit Kupfer bedampft werden. Dies ermöglicht den Einsatz von Karbonfasern in Verbindung mit herkömmlichen Loten. Die Möglichkeit der Beschichtung mit einem leitenden Material für hochbelastbare aber isolierende Materialien besteht natürlich durchweg. Die Fasern aus elektrisch isolierendem Material müssen auch nicht notwendigerweise über ihre gesamte Oberfläche mit elektrischem Material beschichtet sein. Es reicht, wenn ein elektrisch leitender Pfad eingerichtet wird, der aus elektrisch leitendem Material besteht. Auch elektrisch leitende Polymere können verwendet werden, um Fasern bzw. Stäbchen gemäß der Erfindung auszubilden und in den elektrischen Anschluss bzw. den elektrischen Kontakt an eine erfindungsgemäße Funktionseinrichtung einzubinden.

Neben den besagten Polymerfasern und Karbonfasern eignen sich natürlich auch andere Arten von Fasern, beispielsweise Glasfasern, Stahlfasern. All diese Faserarten können einen Kontakt bzw. eine Oberflächenelektrode an einer Funktionseinrichtung gemäß der Erfindung ganz wesentlich stabilisieren, ungeachtet der eigenen Leitfähigkeit einer derartigen Faserart. Wie bereits gesagt, können die Glasfasern, Stahlfasern sowie die übrigen Materialien, seien sie mehr oder weniger leitend oder nicht, zusätzlich noch mit gut leitendem Material wenigstens teilweise oberflächenbeschichtet werden.

Dabei können insbesondere im Hinblick auf eine Oberflächenelektrode die in das Elektrodenmaterial eingebrachten faser- bzw. stäbchenartigen Bestandteile eine Länge aufweisen, so dass aus dem Oberflächenkontakt Fasern herausragen, über die etwa ein Kabel bzw. eine Zuleitung mechanisch stabil und elektrisch leitend angeschlossen werden kann. Dabei ist es auch möglich, beispielsweise für den Zuleitungsanschluss besonders lange faser- bzw. stäbchenartige Bestandteile separat in die Oberflächenelektrode einzubringen, während die Oberflächenelektrode zusätzlich auch entsprechende Verstärkungsfasern bzw. Verstärkungsstäbchen enthält, die sich in dem voranstehenden Längenbereich von ca. 1 mm bis ungefähr 10 mm befinden. Für die Kontaktierung der Oberflächenelektrode können dementsprechend Fasern bzw. Stäbchen vorgesehen werden, die Längen von mehreren Zentimetern aufweisen.

Sollen auch die Zuleitungen zu den Kontakten bzw. Oberflächenelektroden stabilisiert werden, können in die Zuleitungen auch entsprechende Fasern oder Drähte bzw. Litzen eingearbeitet werden, die mechanische Belastungen auf sich nehmen und ein zur Ermüdung neigendes elektrisch leitendes Material dauerhaft entlasten. Wie bereits mehrfach angedeutet, beziehen sich die oben genannten Problematiken insbesondere auf Piezostapelaktoren, die im Niedervoltbereich betreibbar sind und die zur Erzeugung von Schwingungen oder als schnelle mechanische Schalter, etwa bei der Dieseleinspritzung in Dieselmotoren Verwendung finden.

Versuche haben gezeigt, dass insbesondere Kohlenstofffasern wegen ihrer hohen Zugfestigkeit und ihrer günstigen elektrischen Leiteigenschaften geeignet sind, gemäß der Erfindung eingesetzt zu werden. Kohlefasern können auch zur Herstellung von Kabeln oder Litzen als Bestandteil eingesetzt werden, und zur Unterstützung von Metallfasern oder -drähten beispielsweise aus Kupfer dienen.

Dementsprechend können insbesondere auch kurze Kohlefasern eingesetzt werden, um herkömmlichen Kontaktierungsloten bzw. Leitklebern, Leitpasten oder dergleichen zugesetzt zu werden, um eine mechanische Stabilisierung zu bewirken. Nachfolgend wir die vorliegende Erfindung anhand der beigefügten Darstellung unter Bezugnahme auf eine Ausführungsform gemäß der Erfindung näher erläutert, wobei weitere Vorteile, Merkmale und Zielsetzungen gemäß der Erfindung offenbart werden. In den Darstellungen zeigen:
- Fig. 1: eine Prinzipdarstellung eines Piezostapelaktors in einer perspektivischen Darstellung mit einem Teilschnitt; und
- Fig. 2: eine Zuleitung bzw. ein Kabel in einer perspektivischen, teilweise geschnittenen Darstellung.

In den Figuren sind gleiche oder zumindest funktionsgleiche Bestandteile mit den selben Bezugszeichen benannt.

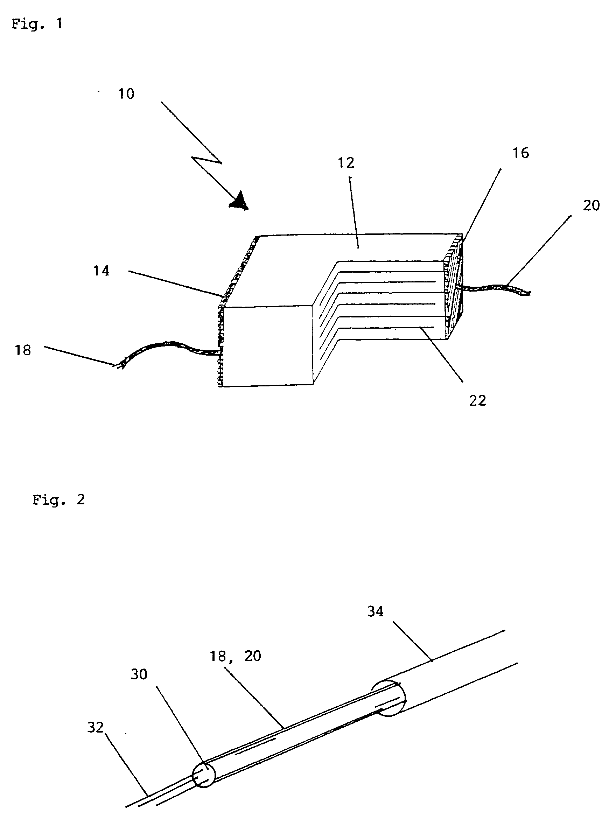

Die Fig. 1 zeigt einen Piezostapelaktor, der generell durch das Bezugszeichen 10 gekennzeichnet ist. Der Piezostapelaktor 10 weist eine Vielzahl von Scheiben 12 auf, die aus piezoelektrisch aktivem Material hergestellt sind, d.h. in der Regel einer Piezokeramik. Innerhalb des Piezoaktors 10 sind zwischen den einzelnen Piezoaktorscheiben bzw. -ebenen oder -platten 12 einzelne interne Oberflächenelektroden 22 vorgesehen, die zum Aufbau elektrischer Felder eingesetzt werden, um die gewünschte mechanische Schwingung erzeugen zu können. Die Elektroden 22 sind abwechselnd an unterschiedliche Oberflächenelektroden 14, 16 angeschlossen, über die eine elektrische Wechselspannung an den Piezoaktor 10 angeschlossen werden kann. Die über die Wechselspannung erzeugte mechanische Dehnung führt zu mechanischen Belastungen in der form von variablen Dehnung des Keramikstapels des Piezoaktors 10, wobei diese Dehnungen an den Kontakten angreifen, die die Dehnungen nicht mitmachen.

Die Oberflächenelektroden 16, 14 sind an Zuleitungen 18, 20 angeschlossen, über die die elektrische Wechselspannung zugeführt wird.

Wenn sich nun die einzelnen Lagen bzw. Ebenen oder Scheiben 12 unter Einwirkung eines hochfrequenten elektrischen Wechselfeldes ausdehnen und wieder zusammenziehen, bleiben die Oberflächenkontakte 14, 16 wie auch die Zuleitungen 18, 20 passiv. Damit sind die Oberflächenelektroden 14, 16 und Zuleitungen 18, 20 hohen mechanischen Belastungen ausgesetzt. An dieser Stelle treten im Stand der Technik häufig Schadstellen auf, die zu einer Beschädigung des Piezoaktors und zu einem Ausfall des Piezoaktors führen können. Um diese Beschädigung so weit als möglich ausräumen zu können, werden dem Material der Oberflächenelektroden 14, 16 mechanisch hochbelastbare Fasern, die selbst elektrisch isolierend und/oder elektrisch leitend sein können, zugesetzt und die mechanische Zugbelastungen sowie mechanische Stauchungsbelastungen aufnehmen können, ohne dass hiervon das Restmaterial des Oberflächenkontaktes bzw. der Oberflächenelektrode 14, 16, dass einen durchgehenden Elektrodenkörper bilden kann, beeinträchtigt wird. Die Fasern bzw. Stäbe innerhalb der Elektroden 14, 16 bilden praktisch ein mechanisch stabilisierendes Gewebegerüst, in dem das elektrisch leitende Material der Elektrode, das im Wesentlichen den Kontakt bereitstellt, entlastet wird.

Durch hohe Schwingungsfrequenzen können auch die Zuleitungen 18, 20 selbst bzw. deren unmittelbare Festlegungsbereiche an den Oberflächenelektroden 14, 16 belastet werden. Hier kann innerhalb der Oberflächenelektroden 14, 16 auch ein Fasermaterial eingebracht sein, das aus Fasern mit einer Länge von mehreren Millimetern bis zu mehreren Zentimetern besteht, und das aus der Elektrode hervorragt. Diese hervor- bzw. herausragenden Fasern können dann eingesetzt werden, um eine mechanisch zusätzlich stabilisierte Kontaktierung zwischen den Zuleitungen 18, 20 und den Elektroden 14, 16 einrichten zu können.

Gemäß Fig. 2 sind die Zuleitungen 18, 20 beispielsweise aus einer Vielzahl von Litzen gebildet, die zusammen ein Kabel 18, 20 mit einer elektrisch isolierenden Ummantelung 34 bilden können.

Die Kabel 18, 20 enthalten dabei elektrisch leitende Fasern bzw. Drähte oder Litzen 20, sowie mechanisch stabilisierende Fasern 32, die gemäß Fig. 2 nur beispielhaft angedeutet sind. Die Anzahl der mechanisch stabilisierenden Fasern und deren Verhältnis zu den elektrisch leitenden Fasern kann abhängig von den aufzunehmenden mechanischen Belastungen bestimmt werden.

## Patentansprüche

1. Funktionseinrichtung (10), insbesondere Piezoaktor bevorzugt Piezostapelaktor, zur Erzeugung von mechanischen Schwingungen, mit wenigstens einem elektrischen Anschluss bzw. wenigstens einem elektrischen Kontakt, etwa Oberflächenkontakt, **dadurch gekennzeichnet, dass** der elektrische Kontakt (14, 16, 22) bzw. der elektrische Anschluss (18, 20) faser- bzw. stäbchenartige Bestandteile aufweist, die den elektrischen Anschluss (18, 20) bzw. den elektrischen Kontakt (14, 16, 22) mechanisch stabilisieren.

2. Funktionseinrichtung nach Anspruch 1, **dadurch gekennzeichnet, dass** die faser-bzw. stäbchenartigen Bestandteile in einer Konzentration vorgesehen sind, so dass sie sich wenigstens stellenweise überlappen und/oder wenigstens stellenweise Perkolationspfade ergeben.

3. Funktionseinrichtung nach einem der Ansprüche 1 oder 2, **dadurch gekennzeichnet, dass** die faser- bzw. stäbchenartigen Bestandteile eine Länge in einem Bereich von etwa 1 mm bis ca. 10 mm aufweisen.

4. Funktionseinrichtung nach einem der Ansprüche 1 bis 3, **dadurch gekennzeichnet, dass** die faser- bzw. stäbchenartigen Bestandteile wenigstens teilweise bzw. jeweils wenigstens eine Wellung, einen Bogen oder dgl. haben, die unter Belastung Stauchungs- bzw. Zugbelastungen kompensieren.

5. Funktionseinrichtung nach einem der Ansprüche 1 bis 4, **dadurch gekennzeichnet, dass** die Fasern bzw. Stäbchen aus elektrisch leitenden und/oder elektrisch isolierendem Material sind.

6. Funktionseinrichtung nach Anspruche 5, **dadurch gekennzeichnet, dass** die Fasern aus elektrisch isolierendem Material einen elektrisch leitenden Pfad umfassen, insbesondere mit elektrisch leitendem Material, beispielsweise Metall, einem elektrisch leitendem Polymer und/oder dgl. beschichtet sind.

7. Funktionseinrichtung nach einem der Ansprüche 1 bis 6, **dadurch gekennzeichnet, dass** die Bestandteile wenigstens eine der nachfolgend aufgeführten Faserarten enthalten:
Glasfasern, Polymerfasern, Stahlfasern, Kohlenstofffasern, Karbonfasern.

8. Funktionseinrichtung nach einem der Ansprüche 1 bis 7, **dadurch gekennzeichnet, dass** der elektrische Kontakt eine Oberflächenelektrode (14, 16) ist, deren Kontaktmaterial der bzw. die Bestandteile hinzugefügt sind, wobei die faser- bzw. stäbchenartigen Bestandteile bevorzugt so lange ausgebildet sind, dass diese einen Zuleitungsanschluss bereitstellen, an dem ein Kabel, ein Draht oder dgl. anschließbar ist.

9. Funktionseinrichtung nach einem der Ansprüche 1 bis 8, **dadurch gekennzeichnet, dass** der elektrische Anschluss Zuleitungen (18, 20) umfasst, die die Verstärkungen aufweisen, die den faser- bzw. stäbchenartigen Bestandteilen entsprechen, wobei die Verstärkungen (32) bevorzugt längere Fasern bzw. Drähte sind, die elektrischen Strom leiten und/oder aus nicht leitendem Material sind.

10. Elektrischer Kontakt bzw. elektrischer Anschluss mit einem elektrisch leitendem Material, **gekennzeichnet durch** einen faser- bzw. stäbchenartigen Bestandteil, wobei die Fasern bzw. Stäbchen mechanisch stabil sind, bevorzugt mit den Merkmalen wenigstens eines der Ansprüche 1 bis 9.
